# EUROPEAN PATENT APPLICATION

(11) **EP 1 909 156 A2**
(43) Date of publication of application: **09.04.2008**
(21) Application number: 07253076.9
(22) Date of filing: 03.08.2007
(51) Int. Cl.: G05B 19/418

(54) **A control system and an interface therefor**

(30) Priority: 23.11.2006 SG 200608050; 06.10.2006 SG 200606866
(71) Applicant: Kyodo-Allied Industries Ltd, Singapore 628771 (SG)
(72) Inventor: Lee, Zong Tang, Singapore 229668 (SG)
(74) Representative: Howe, Steven

(57) **Abstract**

An interface is disclosed that is locatable between a server and at least one operational system for a clean room. The interface has a memory configured to store a copy of control settings from a control signal sent from the server to the at least one operational system; and a processor configured to send a control signal to the at least one operational system based on the stored copy of the control settings, if a predetermined condition is met.

## Description

### TECHNICAL FIELD

This invention relates to a control system and an interface therefore and refers particularly, though not exclusively, to a control system and an interface therefor between a server and at least one operational system for a clean room or a clean zone.

### BACKGROUND

In certain manufacturing processes it is desirable to reduce the level of airborne containments. For example, in semiconductor manufacturing or laboratories it is common to use "clean rooms" where the level of airborne contaminants is below a strict standard. For example Federal Standard 209E developed by the U.S. General Services Administration and ISO 14644-1/2 developed by the International Organization for Standardization establish standard classes of air cleanliness for airborne particulate levels in clean rooms and clean zones.

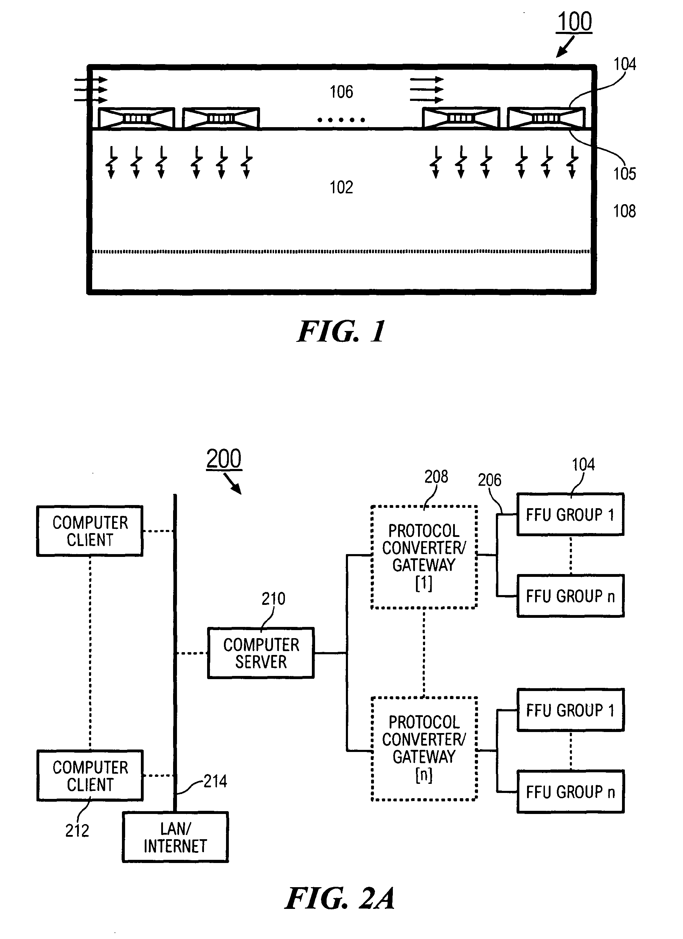

An example of a prior art clean room 100 is shown in Figure 1. A substantially sealed interior 102 is provided with clean air from a series of fan filter units ("FFUs) 104 mounted on or in the ceiling 105. Each FFU 104 receives air from the air supply system 106. Each FFU 104 has at least one filter to remove contaminants from the air. The filter may be, for example a High Efficiency Particulate Air (HEPA) filter and/or Ultra Low Penetration Air (ULPA) filter. The flow through the filter into the interior 102 is controlled by a fan. The fan preferably generates a laminar flow through the filter. The fan may be driven by a variable speed AC or DC motor.

The FFUs 104 are typically operated to create a pressure in the interior 102 which is higher than the pressure of the exterior 108 and the air supply system 106. This overpressure prevents any "dirty" air or contamination from outside 108 or from the within the air supply system 106 from leaking into the interior 102. The higher the pressure difference, the lower is the chance of contamination.

There are many reasons why a given FFU 104 may produce a lower than expected airflow. The most common reason is that the filter is blocked. What ever the reason, if the required airflow is not generated the pressure in the clean room may drop. That means there is a higher chance of contamination.

Also, in an installation where there are a large number of FFUs, the situation in one region of the installation may be different to that in another region. For example, one region may suffer from an output of a gas or other atmospheric contaminant. In that case the particular region may require the FFUs to be switched off very quickly to minimize distribution of the gas.

An example of a prior art clean room control system 200 is shown in Figure 2(a). Each FFU 104 is connected via a network 206 and an associated protocol converter/gateway 208 to a server 210. The server 210 in turn may be connected to one or more client terminals 212 via a network 214. The FFUs 104 may be arranged in groups with there being two or more FFUs in each group. Each group has a gateway 208. Protocol conversion in a gateway 208 may be required if the instructions for the FFUs in the relevant group are in a format or protocol not suitable for the FFUs.

The overall pressure in the room may be set and/or monitored using the client terminals and software loaded on the server. The software may allow the speeds of individual FFUs to be set if desired, and the actual speed detected by the sensor may be able to be logged. The software accordingly controls each FFU through the network to deliver the desired performance.

However in the event of a network or hardware failure, control of the FFUs will be lost. The only alternative it is to connect an individual manual controller to each FFU, which can be very time consuming, and may result in contamination. Also, urgent localized control of an individual FFU, or a group of FFUs, is not possible. This is also applicable to other operational systems of the clean room including, but not limited to: air showers, building management system, lighting system, alarm system, security system, temperature control system, and air flow control system.

### SUMMARY

In general terms in a first aspect the invention proposes that in a clean room control system each gateway is an interface that locally stores the control settings which are synchronised with the central server. This may have the advantage that the interface can operate each operational system according to the locally stored settings.

In a second independent aspect in a clean room control system each interface may have a control panel that allows local control of the operational system. This may have the advantage that the interface can operate each operational system according to localized user settings.
In a first exemplary aspect there is provided an interface between a server and at least one operational system for a clean room, the interface comprising:
a memory configured to store a copy of control settings from a control signal sent from the server to the at least one operational system; and
a processor configured to send a control signal to the at least one operational system based on the stored copy of the control settings, if a predetermined condition is met.
The interface may further comprise a user interface configured to receive user settings; and the processor may be configured to send a control signal to the at least one operational system based on at least one of: the stored copy of the control settings, and the user settings. The at least one operational system may be at least one of: a plurality of fan filter units, an air shower system, building management system, lighting system, alarm system, security system, temperature control system, and air flow control system. The user settings may be for one of: a single fan filter unit, a lesser plurality of fan filter units, a group of fan filter units, and a plurality of groups of fan filter units.
According to a second exemplary aspect there is provided an interface between a server and at least one operational system for a clean room or a clean zone, the interface comprising:
a user interface configured to receive user settings;
a memory configured to store control settings receivable from a server; and
a processor configured to send a control signal to the at least one operational system based on at least one of: the stored control settings, and the user settings, if a predetermined condition is met.
For both aspects, the at least one operational system may be at least one of: a plurality of fan filter units, an air shower system, building management system, lighting system, alarm system, security system, temperature control system, and air flow control system. The user settings may be for one of: a single fan filter unit, a lesser plurality of fan filter units, a group of fan filter units, and a plurality of groups of fan filter units. The plurality of fan filter units may be arranged in a manner selected from: as single fan filter units, a group of fan filter units, and a plurality of groups of fan filter units.
The predetermined condition may relate to a communication failure between the server and the interface, or local control of the interface being enabled.
The control signal may be configured to operate in a first protocol and the processor may be further configured to convert the control signal from the server to a control signal having a second protocol. The interface may further comprise a port configured to receive a protocol converter and wherein the protocol converter is for converting the first protocol to the second protocol.
The user interface may comprise a touch screen. The memory may be connected to the processor.
According to a third exemplary aspect there is provided a control system for at least one operational system comprising at least one interface as described above.
There may be a plurality of interfaces. The plurality of interfaces may be located between the server and the at least one operational system. The at least one operational system may be operatively connectable to the plurality of interfaces by an operational system network. Each interface further may comprise a first network interface for receiving the control signal and the control settings, and a second network interface connectable to the operational system network. The stored copy of the control signals may be a copy of the last received control signals. The user settings may override the control settings. The at least one operational system may be at least one of: a plurality of fan filter units, an air shower system, building management system, lighting system, alarm system, security system, temperature control system, and air flow control system.
For all aspects the user settings may be for at least one of: a plurality of fan filter units, an air shower system, building management system, lighting system, alarm system, security system, temperature control system, and air flow control system.

### BRIEF DESCRIPTION OF THE DRAWINGS

In order that the invention may be fully understood and readily put into practical effect there shall now be described by way of non-limitative example only preferred embodiments of the present invention, the description being with reference to the accompanying illustrative drawings.
In the drawings:
Figure 1 is a schematic diagram of a prior art clean room;
Figure 2(a) is a block diagram of a prior art control system;
Figure 2(b) is a block diagram of an exemplary embodiment of an FFU motor speed controller;
Figure 3 is a block diagram of a control system according to an exemplary embodiment;
Figure 4 is a block diagram of the interface in Figure 3;
Figure 5 is a flow diagram of the operation of the interface of Figure 4; and
Figure 6 is a block diagram of a control system according to another exemplary embodiment.

### DETAILED DESCRIPTION

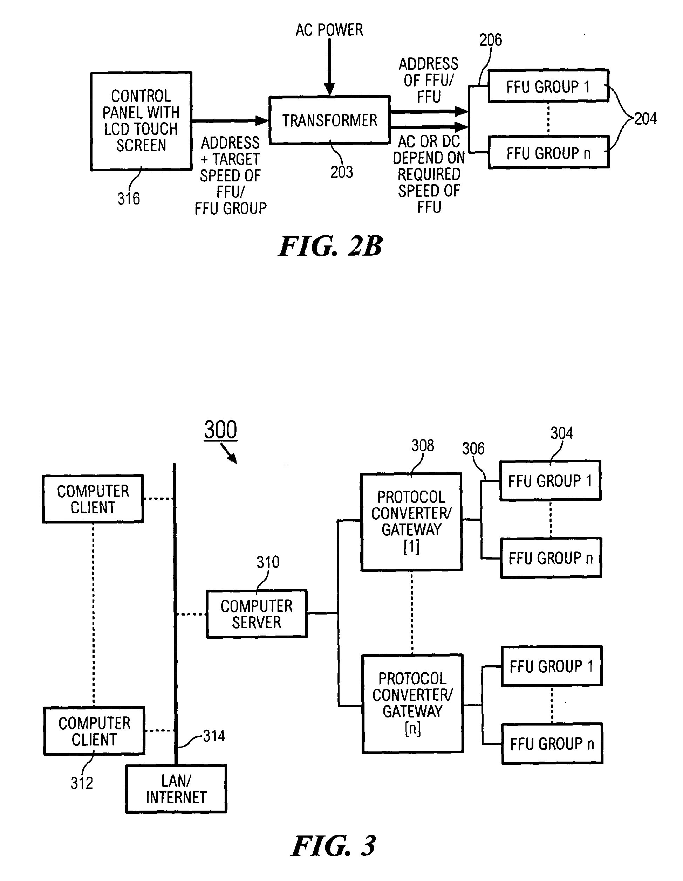

Figures 2(b) and 3 show a control system 300 for a clean room according to an exemplary embodiment. Each FFU or group of FFUs 204, 304 is connected via an FFU network 306 to an associated control interface 308. Each interface 308 may be for a single FFU, a single group of FFUs, a plurality ofFFUs, or a plurality of groups of FFUs. Each interface 308 is connected to a server 310. The server 310 may be connected to one or more client terminals 312 via a network 314. Each interface 308 may have an associated control panel 316.

A master motor controller 203 is provided for each FFU, group of FFUs or groups of FFUs, as shown in Figure 2(b). The motor controller for each FFU may have open loop or closed loop control via a sensor (not shown), may control based on a desired motor speed, desired air flow, or desired pressure, and may be as simple as a variable voltage applied to the motor windings (e.g.: for a DC motor), or more complicated variable frequency drives (for Induction or PMAC drives).

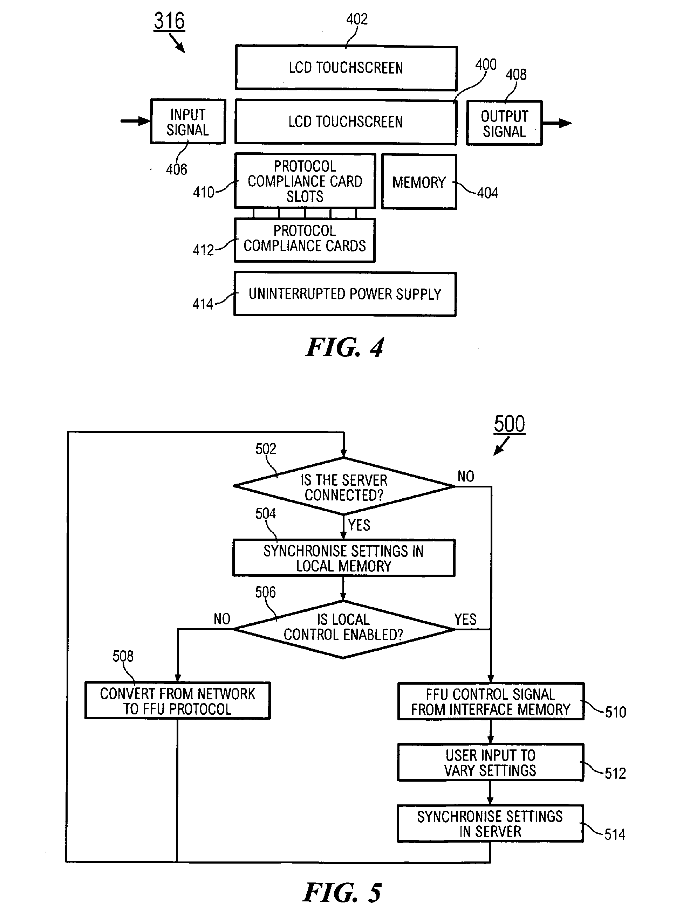

Referring to Figure 4, the control panel 316 is shown in more detail. A processor 400 is connected to a touch panel 402 that may be of any suitable form such as, for example, an LCD touch panel. The processor 400 is also connected to a memory 404. A first network interface 406 receives data from the server network 314 and/or other interfaces. A second network interface 408 connects to the FFU network 306. A port 410 is used to connect an interchangeable protocol converter 412 (a different converter is connected to the port depending on the protocol of the FFU network). Both network interfaces are connected to the processor 402 and to the protocol converter 412. Protocol compliance card 412 performs all the necessary protocol conversion so the FFUs 304 can act on the received instructions. By having a protocol compliance card slot 410 and a range of protocol compliance cards, the one control panel can be used for a large range of FFUs and servers 310, and separate control panels for different FFUs 304/servers 310 will not be required. If the operating system of server 310 is changed, all that need be changed is the protocol compliance card 412 for each interface 308 to maintain the system operative. The external connections (not shown) include an Ethernet connection to the server, RS485 ports for connection to the FFU groups and a power supply connection. A power supply 414 such as, for example, an uninterrupted power supply, may be provided to supply power to the control panel 316.

The operation of the interface 308 is shown in more detail in Figure 5. In normal server control mode the FFUs 304 are controlled by the server 310. At the interface 308, communication with the server 310 is checked to determine whether the server 310 is connected and functioning correctly (communication test step 502). If the server 310 is connected, a synchronised copy of the control settings from the server 310 is periodically stored in the interface memory 404 (synchronisation step 504). The interface memory 404 includes a register storing whether or not local control is enabled from the LCD touch panel 402 (local control test step 506). In normal server control mode (if the server 310 is connected and local control is not enabled) the protocol converter 412 converts the control signals from the server network protocol e.g.: TCP/IP, into the appropriate protocol for the FFU network 306 e.g.: RS485 or LONWORKS (conversion step 508).

If communication with the server 310 is lost for any reason, or if local control is enabled, local control immediately commences. The processor 400 generates the control signals to operate the FFUs 304 from the settings stored in the interface memory 404 (local control step 510). Initially these settings are the last stored synchronised settings as received from the server 310 before local control commenced. However, complete control over the settings is provided using the LCD touch panel 402 so that a user can override the control settings. For example a user can vary the settings for a specific FFU, groups of FFUs or the entire clean room (local setting step 512). The signal provided to the FFU network 306 will include an address for the FFU or FFU group and the desired setting for that address. When the server 310 is again connected, or local control cancelled, a synchronised copy of the control settings from the interface memory 404 is periodically stored in the server 310 (backwards synchronisation step 514). Therefore, in case of an interface hardware failure or a server hardware failure, the settings (either from the server 310 or the interface 308) will be backed-up in the other location and will not be lost.

The LCD touch panel 402 may be located at any location in the clean room, and may be connected to the interface 308 via a wired or wireless connection. It allows easy adjustment of the operating point within the clean room. This eliminates the need to change the operating point at the control room and then separately verify the changes in the clean room. This may be useful during construction of the clean room when part of the clean room may be undergoing testing and commission and the control room is not ready, in the event of a regionalized problem, or otherwise as required or desired.

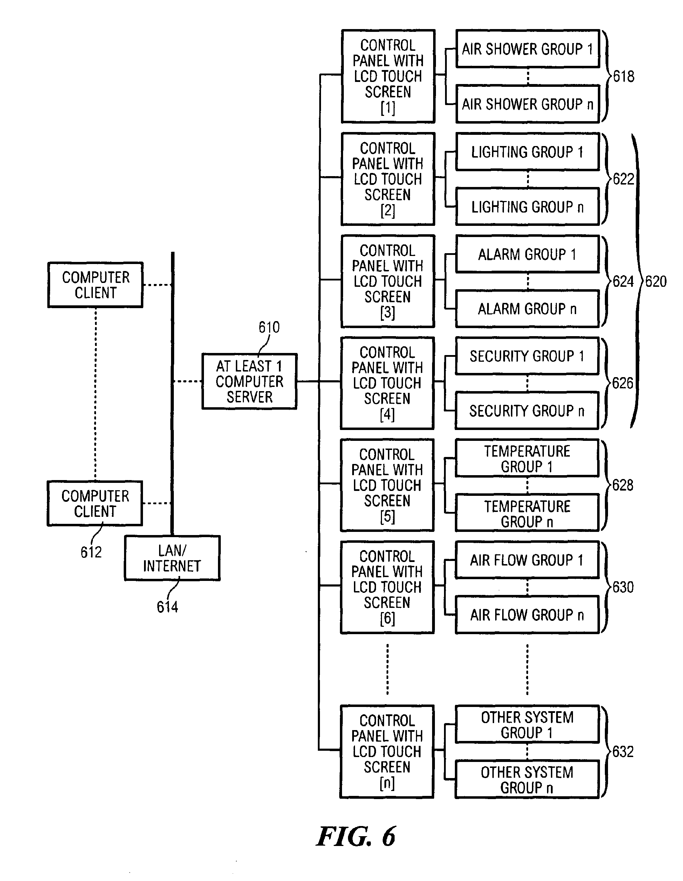

Figure 6 shows another exemplary embodiment where the control panels 616 are used to control other functions within the clean room, or even throughout the building. The operating system is as described above for each of the other functions. The other functions include, but are not limited to: air showers 618, building management system 620, lighting system 622, alarm system 624, security system 626, temperature control system 628, air flow control system 630, and any other desired or required system 632. These may be arranged in groups, or individually. This may be in addition to or in place of the control of the FFUs 204, 304 described above. In this case the user settings are for one or more of: the fan filter units 204/304, air shower system 618, building management system 620, lighting system 622, alarm system 624, security system 626, temperature control system 628, air flow control system 630, and any other desired or required system 632.

For example, the control panel 616 may also be used to control an air shower system 618. The air shower system 618 serves as a control gateway to the cleanliness to a clean room. It serves to remove particles from people and material entering the clean room. In a large clean room, where there may be a relatively large number of air showers 618 such as, for example, between 10 and 20 air showers 618, the proper operation and control of air showers 618 is of importance in the overall clean room operation. For example, the duration of air blowing in an air shower 618 may need to be adjusted according to the clean room cleanliness conditions. The relevant setting may be adjusted by use of a computer server or the control panels 616, with the adjustment made depending on the result of the particle count sensor. Different air showers 618 can be programmed to operate differently depending on the usage pattern of the air showers 618.

The control panels 616 may provide sufficient flexibility, and safety net, for the overall control and monitoring of the air shower system 618, with the operation being as described above.

The control panels 616 may also be used to also control building management systems 620 such as, for example, lighting 622, alarms 624 (including particle count and climate control alarms), and security systems 626. Building services such as lighting 622, alarm 624 and security systems 626 are often controlled as part of the building management system 620. This provides an efficient and effective way to manage such services. By using the control panels 616 it is possible to provide a flexible system for the overall control and monitoring of the various components under the building management system ("BMS") 620.

By using the control panels 616, it is possible to resolve the problem of each component 622, 624, 626 operating under a different communication protocol. This can be done by utilizing the protocol converter feature as described above.

In the event of a failure of the BMS 620, the operation of the various services can still be controlled in the manner described above. As such, and upon restoration of the BMS 620, all changes can be automatically updated to the system.

The control panels 616 may also be connected to and control the temperature 628 and air flow monitoring and/or control system 630. Temperature and air flow are some of the most crucial factors in a clean room system as the products being manufacture in a clean room are generally sensitive to temperature change. Any products produced outside the allowable temperature range may be rendered useless, or may have to be scrapped. By using the control panels 616 to control the temperature control system628 and air flow system 630, in the event of a malfunction of the control server, the control panels 616 can assume the function of monitoring temperature and air flow in the clean room and allow manual or automatic adjustment to achieve the required parameters. Updates would happen as described above.

Whilst there has been described in the foregoing description preferred embodiments of the present invention, it will be understood by those skilled in the technology concerned that many variations in details of design, construction and/or operation may be made without departing from the present invention.

## Claims

1. An interface between a server and at least one operational system for a clean room, the interface comprising:
a memory configured to store a copy of control settings from a control signal sent from the server to the at least one operational system; and
a processor configured to send a control signal to the at least one operational system based on the stored copy of the control settings, if a predetermined condition is met.

2. The interface as claimed in claim 1 further comprising a user interface configured to receive user settings; and the processor is configured to send a control signal to the at least one operational system based on at least one of: the stored copy of the control settings, and the user settings.

3. The interface as claimed in claim 2, wherein the at least one operational system is at least one selected from the group consisting of: a plurality of fan filter units, an air shower system, building management system, lighting system, alarm system, security system, temperature control system, and air flow control system.

4. The interface as claimed in claim 2, wherein the user settings are for at least one selected from the group consisting of: a single fan filter unit, a plurality of fan filter units, a group of fan filter units, a plurality of groups of fan filter units, an air shower system, building management system, lighting system, alarm system, security system, temperature control system, and air flow control system.

5. An interface between a server and at least one operational system for a clean room or a clean zone, the interface comprising:
a user interface configured to receive user settings;
a memory configured to store control settings receivable from a server; and
a processor configured to send a control signal to the at least one operational system based on at least one of: the stored control settings, and the user settings, if a predetermined condition is met.

6. The interface as claimed in claim 5, wherein the at least one operational system is at least one selected from the group consisting of: a plurality of fan filter units, an air shower system, building management system, lighting system, alarm system, security system, temperature control system, and air flow control system.

7. The interface as claimed in claim 5, wherein the user settings are for at least one selected from the group consisting of: a single fan filter unit, a plurality of fan filter units, a group of fan filter units, a plurality of groups of fan filter units, an air shower system, building management system, lighting system, alarm system, security system, temperature control system, and air flow control system.

8. The interface as claimed in any one of claims 2 to 7, wherein the predetermined condition relates to at least one selected from the group consisting of: a communication failure between the server and the interface, and local control at the interface being enabled.

9. The interface as claimed in any of the preceding claims, wherein the control signal is configured to operate in a first protocol and wherein the processor is further configured to convert the control signal from the server to a control signal having a second protocol.

10. The interface as claimed in claim 9 further comprising a port configured to receive a protocol converter, the protocol converter being for converting the first protocol to the second protocol; the user interface comprises a touch screen; and the memory is connected to the processor.

11. A control system for at least one operational system of a clean room, the control system comprising at least one interface as claimed in any one of claims 1 to 10.

12. A control system as claimed in claim 11, wherein there is a plurality of interfaces, the plurality of interfaces being located between the server and the at least one operational system.

13. A control system as claimed in claim 12, wherein the at least one operational system is operatively connectable to the plurality of interfaces by an operational system network.

14. A control system as claimed in claim 13, wherein the interface further comprises a first network interface for receiving the control signal and the control settings, and a second network interface connectable to the operational system network.

15. A control system as claimed in any one of claims 11 to 14, wherein the stored copy of the control signals are a copy of the last received control signals.

16. A control system as claimed in any one of claims 11 to 15, wherein the user settings override the control settings.

17. A control system as claimed in any one of claims 11 to 16, wherein the at least one operational system is at least one selected from the group consisting of: a plurality of fan filter units, an air shower system, building management system, lighting system, alarm system, security system, temperature control system, and air flow control system.

18. A control system as claimed in any one of claims 11 to 17, wherein the user settings are for at least one selected from the group consisting of: a single fan filter unit, a plurality of fan filter units, a group of fan filter units, and a plurality of groups of fan filter units, an air shower system, building management system, lighting system, alarm system, security system, temperature control system, and air flow control system.
